# EUROPEAN PATENT APPLICATION

(11) **EP 1 403 403 A1**
(43) Date of publication of application: **31.03.2004**
(21) Application number: 02741236.0
(22) Date of filing: 21.06.2002
(51) Int. Cl.: C30B 29/28, C30B 19/12

(54) **SUBSTRATE FOR FORMING MAGNETIC GARNET SINGLE CRYSTAL FILM, OPTICAL DEVICE, AND ITS PRODUCTION METHOD**

(30) Priority: 22.06.2001 JP 2001189587
(71) Applicant: TDK Corporation, Chuo-ku, Tokyo 103-8272 (JP)
(72) Inventor: SAKASHITA, Yukio, c/o TDK Corporation, Tokyo 103-8272 (JP); KAWASAKI, Katsumi, c/o TDK Corporation, Tokyo 103-8272 (JP); OHIDO, Atsushi, c/o TDK Corporation, Tokyo 103-8272 (JP); MORIKOSHI, Hiroki, c/o TDK Corporation, Tokyo 103-8272 (JP); UCHIDA, Kiyoshi, c/o TDK Corporation, Tokyo 103-8272 (JP); YAMASAWA, Kazuhito, c/o TDK Corporation, Tokyo 103-8272 (JP)
(74) Representative: VOSSIUS & PARTNER
(86) International application number: PCT/JP2002/006223
(87) International publication number: WO 2003/000963

(57) **Abstract**

A magnetic garnet single crystal film formation substrate for growing a magnetic garnet single crystal film by liquid phase epitaxial growth is provided. This substrate comprises a base substrate composed of a garnet-based single crystal which is unstable with a flux used for the liquid phase epitaxial growth and a buffer layer composed of a garnet-based single crystal thin film formed on the base substrate and being stable with said flux. A high-quality magnetic garnet single crystal film can be produced by using the substrate. The magnetic garnet single crystal film is used as an optical element, such as a Faraday element, used in an optical isolator, optical circulator and magneto-optical sensor, etc.

## Description

### TECHNICAL FIELD

The present invention relates to a magnetic garnet single crystal film formation substrate for growing a magnetic garnet single crystal film of, for example, bismuth-substituted rare earth iron garnet (Bi-RIG) by liquid phase epitaxial growth, a method of producing a single crystal film for performing crystal growth by using the substrate, and a single crystal film and an optical aliment produced by the production method.

### BACKGOUND ART

As a material of an optical element, such as a Faraday rotator used in an optical isolator, optical circulator and optical magnetic field sensor, etc., what obtained by growing a magnetic garnet single crystal film on a single crystal substrate by epitaxial growth is generally used. The magnetic garnet single crystal film to be grown on the substrate is desired to have a large Faraday rotation coefficient to obtain desired Faraday effects. Also, to form a high quality single crystal film by epitaxial growth, it is required that a lattice constant difference between the substrate single crystal and the single crystal to be grown is as small as possible in a temperature range from a film forming temperature to the room temperature.

It is known that the Faraday rotation coefficient of the magnetic garnet single crystal film remarkably increases by substituting a part of the rare earth components with bismuth. An increase of a bismuth substitution amount brings an increase of a lattice constant of the magnetic garnet single crystal film at the same time, so that a substrate material used for the film forming is also required to have a larger lattice constant and, for example, gadolinium gallium garnet (GGG) added with Ca, Zr and Mg, etc. to obtain a large lattice constant is used as the single crystal substrate material (The Japanese Examined Patent Publication No. 60-4583).

However, in the case of growing bismuth-substituted rare earth iron garnet single crystal on the GGG single crystal substrate added with Ca, Zr and Mg, etc. to be a thick film (a film thickness of, for example, 200 µm or more), the substrate and the single crystal layer during and after the film forming are liable to warp and crack, which is a cause of declining production yields at the time of the film forming and processing.

To eliminate the problem, the present inventors have proposed a garnet single crystal substrate of a specific composition wherein a thermal expansion coefficient within a face being perpendicular to the crystal orientation <111> is a value extremely close to that of the bismuth-substituted rare earth iron garnet in a temperature range from the room temperature to 850°C (The Japanese Unexamined Patent Publication No. 10-139596). By using this single crystal substrate, it is possible to form a thick film bismuth-substituted rare earth iron garnet single crystal film by liquid phase epitaxial growth wherein crystal defects, warps and cracks, etc. are not caused.

However, it was found by the present inventors that the garnet single crystal substrate of this specific composition was unstable with lead oxide flux used as a deposition medium at the time of performing the liquid phase epitaxial growth of bismuth-substituted rare metal iron garnet (Bi-RIG) single crystal film, so the yields of obtaining high quality bismuth-substituted rare earth iron garnet single crystal was poor. Particularly, it was found that this tendency was strong in a substrate composition containing Nb or Ta.

### DISCLOSURE OF THE INVENTION

An object of the present invention is to provide a magnetic garnet single crystal film formation substrate capable of stably forming a thick magnetic garnet single crystal film, wherein crystal defects, warps and cracks, etc. are not caused, by liquid phase epitaxial growth, an optical element and a method of producing the same.

A magnetic garnet single crystal film formation substrate (substrate for forming magnetic garnet single crystal film) according to the present invention for growing a magnetic garnet single crystal film by liquid phase epitaxial growth, comprises
a base substrate composed of a garnet-based single crystal which is unstable with a flux used for the liquid phase epitaxial growth, and
a buffer layer composed of a garnet-based single crystal thin film formed on the base substrate and being stable with the flux.

The above flux is not particularly limited, but is a flux having, for example, a lead oxide as a component. Note that "being unstable with a flux" in the present invention means that, in a so-called supersaturated state where a solute component in the flux starts to crystallize by using an object substance (a base substrate or buffer layer) as a core, at least a part of a material composing the object substance is eluted (soluted) to the flux and/or at least a part of the flux component is diffused to the object substance to hinder the liquid phase epitaxial growth of a single crystal film. Also, "being stable with a flux" means a reverse phenomenon of the "being unstable with a flux".

According to the present invention,

It is possible to select a garnet single crystal substrate of a specific composition having an extremely close thermal expansion coefficient to that of a magnetic garnet single crystal, for example, bismuth-substituted rare earth iron garnet to be an object of forming by liquid phase epitaxial growth and, even when the substrate is unstable with the flux, stable liquid phase epitaxial growth can be performed. It is because a buffer layer being stable with a flux is formed on the base substrate.

Thus, in the present invention, a bismuth-substituted rare earth iron garnet single crystal film used in a Faraday rotator and other optical elements can be formed by liquid phase epitaxial growth at a high quality while suppressing arising of crystal defects, warps, cracks and flaking, etc. Namely, according to the present invention, a relatively thick (for example, 200 µm or more) and wide (for example, a diameter of 3 inches or more) magnetic garnet single crystal film can be obtained by liquid phase epitaxial growth.

Preferably, the base substrate has approximately the same thermal expansion coefficient as that of the magnetic garnet single crystal film. For example in a temperature range of 0°C to 1000°C, the difference of the thermal expansion coefficient of the base substrate is within a range of ±2 × 10⁻⁶/°C or less with respect to the thermal expansion coefficient of the magnetic garnet single crystal film.

By making the thermal expansion coefficient of the base substrate approximately the same with that of the magnetic garnet single crystal film, deterioration of quality, such that a film after epitaxial growth comes off from the substrate and cracks and chips, etc. (hereinafter, also referred to as "cracks, etc."), can be effectively prevented. It is because, at the time of forming a magnetic garnet single crystal film by epitaxial growth, the temperature rises nearly 1000°C and returns to the room temperature, so cracks, etc. easily arise on the epitaxial growth film when the thermal expansion coefficients are different.

Note that the thermal expansion coefficient of the buffer layer is not necessarily approximately the same with that of the magnetic garnet single crystal film. It is because a film thickness of the buffer layer is extremely thin with respect to a thickness of the base substrate and the thermal expansion difference affects a little on the epitaxial growth film.

Preferably, the base substrate has approximately the same lattice constant as that of the magnetic garnet single crystal film. For example, the difference of the lattice constant of the base substrate is in a range of ±0.02Å or less with respect to the lattice constant of the magnetic garnet single crystal film.

By making the lattice constant of the base substrate approximately the same as that of the magnetic garnet single crystal film, the magnetic garnet single crystal film is easily grown by liquid phase epitaxial growth.

Preferably, the base substrate includes Nb or Ta. When Nb or Ta is included in the base substrate, the thermal expansion coefficient and/or lattice constant of the base substrate is easily made approximately the same as the lattice constant of the magnetic garnet single crystal film. Note that when Nb or Ta is included in the base substrate, stability with a flux is liable to decline.

Preferably, the buffer layer is a garnet-based single crystal thin film substantially not including Nb and Ta. It is because a garnet-based single crystal thin film substantially not including Nb and Ta is relatively stable with a flux.

Preferably, the buffer layer is
expressed by a general formula R₃M₅O₁₂ (note that R is at least one of rare earth elements and M is one selected from Ga and Fe)
or
an X-substituted gadolinium gallium garnet (note that X is at least one of Ca, Mg and Zr).

The buffer layer composed of a material as above is preferable for being relatively stable with a flux and, moreover, having a lattice constant close to that of a magnetic garnet single crystal film.

Preferably, a thickness of the buffer layer is 1 to 10000 nm, more preferably 5 to 50 nm, and a thickness of the base substrate is 0.1 to 5 mm, more preferably 0.2 to 2.0 mm. When the thickness of the buffer layer is too thin, an effect of the present invention becomes small, while when it is too thick, the cost becomes high and it is liable to adversely affect on the epitaxial growth film, such as cracks, due to a difference of thermal expansion coefficient. Also, when the thickness of the base substrate is too thin, it is liable that mechanical strength becomes insufficient and handling becomes deteriorated, while when it is too thick, arising of cracks, etc. is liable to increase.

A method of producing a magnetic garnet single crystal film according to the present invention includes the step of growing a magnetic garnet single crystal film on the buffer layer by using the magnetic garnet single crystal film formation substrate by a liquid phase epitaxial growth method.

A method of producing an optical element according to the present invention includes the steps of forming a magnetic garnet single crystal film by using the method of producing a magnetic garnet single crystal film of the present invention, and after that, removing the base substrate and buffer layer in order to form an optical element composed of the magnetic garnet single crystal film.

An optical element according to the present invention is obtained by the method of producing an optical element of the present invention.

### BRIEF DESCRIPTION OF DRAWINGS

Fig. 1 is a sectional view of a magnetic garnet single crystal film formation substrate according to an embodiment of the present invention and a bismuth-substituted rare earth iron garnet single crystal film grown by using the same.
FIG. 2A is a SEM image of a surface of a magnetic garnet single crystal film formation substrate according to an example of the present invention.
FIG. 2B is a SEM image of a section of the substrate shown in FIG. 2A.
FIG. 3 is a sectional SEM image in a state that a bismuth-substituted rare earth iron garnet single crystal film is formed on a surface of a magnetic garnet single crystal film formation substrate according to an example of the present invention.
FIG. 4A is a SEM image of a surface in a state that a bismuth-substituted rare earth iron garnet single crystal film is formed on a magnetic garnet single crystal film formation substrate according to an example of the present invention.
FIG. 4B is a SEM image of a surface in a state that a bismuth-substituted rare earth iron garnet single crystal film is formed on a surface of a magnetic garnet single crystal film formation substrate according to a comparative example of the present invention.
FIG. 5A and FIG. 5B are pictures in a state that a bismuth-substituted rare earth iron garnet single crystal film is formed on a surface of a magnetic garnet single crystal film formation substrate according to an example and a comparative example of the present invention.

### BEST MODE FOR CARRYING OUT THE INVENTION

Below, the present invention will be explained in detail based on embodiments shown in the drawings.

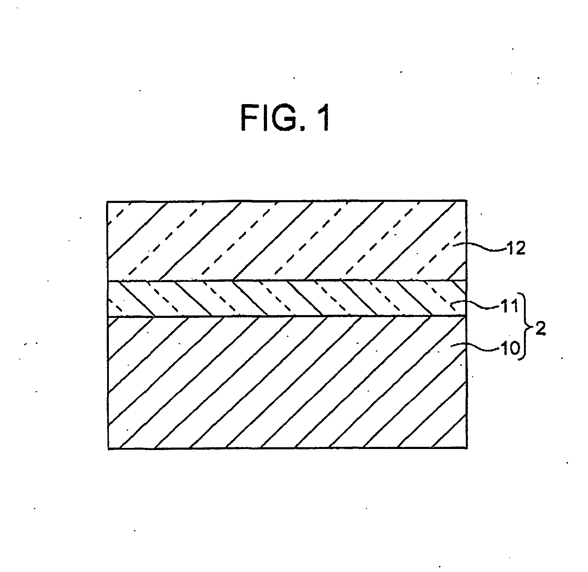

As shown in FIG. 1, a magnetic garnet single crystal film formation substrate 2 in the present embodiment comprises a base substrate 10 and a buffer layer 11 formed by stacking on a surface of the base substrate 10. The base substrate 10 has a lattice constant and thermal expansion coefficient being extremely close to those of a magnetic garnet single crystal film 12 made by bismuth-substituted rare earth iron garnet single crystal but is unstable with a lead oxide flux. The buffer layer 11 is composed of a garnet-based single crystal thin film being stable with a lead oxide flux.

A bismuth-substituted rare earth iron garnet single crystal film 12 is grown on the buffer layer 11 in the substrate 2 by liquid phase epitaxial growth. The base substrate 10 has preferable lattice matching property with the single crystal film 12 for growing the magnetic garnet single crystal film 12 via the buffer layer 11 and the linear thermal expansion coefficient of the substrate has a characteristic close to that of the single crystal film 12.

The base substrate 10 is composed of, for example, nonmagnetic garnet-based single crystal expressed by a general formula M1ₓM2_{y}M3_{z}O₁₂. In this general formula, M1 is an element, for example, selected from Ca, Sr, Cd and Mn. As the M1, those existing stably when having 2+ valence number, having a coordination number of 8, having an ion radius in a range of 0.096 to 0.126 nm in this state are preferable. The M2 is an element, for example, selected from Nb, Ta and Sb. As the M2, those existing stably when having 5+ valence number, having a coordination number of 6, having an ion radius in a range of 0.060 to 0.064 nm in this state are preferable. The M3 is an element, for example, selected from Ga, Al, Fe, Ge, Si and V. As the M3, those existing stably when having 3+, 4+ or 5+ valence number, having a coordination number of 4, having an ion radius in a range of 0.026 to 0.049 nm in this state are preferable. Note that the ion radius is a value of an effective ion radius defined by R. D. Shannon. The M1, M2 and M3 may be a single element or combination of two or more kinds of elements.

Furthermore, in the element of the M1, a part thereof may be substituted with an element M4 which is substitutable with Ca or Sr in the composition in a range of less than 50 atomic% in accordance with need in order to adjust the valence number and lattice constant. As the M4, for example, at least one kind selected from Cd, Mn, K, Na, Li, Pb, Ba, Mg, Fe, Co, rare earth elements and Bi and those capable of having a coordination number of 8 are preferable.

Also, in the M2, in the same way as in the M1, a part thereof may be substituted with an element M5 which is substitutable with Nb, Ta or Sb in the composition in a range of less than 50 atomic%. As the M5, for example, at least one kind selected from Zn, Mg, Mn, Ni, Cu, Cr, Co, Ga, Fe, Al, V, Sc, In, Ti, Zr, Si and Sn and those capable of having a coordination number of 6 may be preferably mentioned.

The single crystal substrate having a composition as above has a thermal expansion coefficient close to that of bismuth-substituted rare earth iron garnet single crystal to be grown and has preferable lattice matching property with the single crystal. Particularly, in the above general formula, those having values of "x" in a range of 2.98 to 3.02, "y" in a range of 1.67 to 1.72, and "z" in a range of 3.15 to 3.21 are preferable.

The thermal expansion coefficient of the base substrate 10 having the above composition is 1.02 × 10⁻ ⁵/°C to 1.07 × 10⁻⁶/°C or so in the room temperature to 850°C, which very much approximates the linear thermal expansion coefficient of 1.09 × 10⁻⁵/°C to 1.16 × 10⁻⁵/°C of bismuth-substituted rare earth iron garnet single crystal film in the same temperature range.

Also, the thickness of the base substrate 10 is not particularly limited, but the thickness is preferably 1.5 mm or less in terms of suppressing arising of cracks and warps, etc. of the substrate and the single crystal film at the time of film forming when forming a bismuth-substituted rare earth iron garnet single crystal film having a film thickness of 200 µm or more, so that a preferable single crystal film can be obtained. When the thickness of the base substrate exceeds 1.5 mm, there is a tendency that arising of cracks increases near a boundary surface of the substrate and the single crystal film along with an increase of the thickness. Also, when the thickness of the single crystal substrate 10 becomes too thin, mechanical strength becomes small and handleability becomes poor, so that those having a thickness of 0.1 mm or more are preferable.

The buffer layer 11 formed on the single crystal substrate 10 is composed of a garnet-based single crystal thin film. As the garnet-based single crystal thin film, what expressed by a general formula R₃M₅O₁₂ (note that R is at least one kind of rare earth elements and M is one kind selected from Ga and Fe), or X-substituted gadolinium gallium garnet (note that X is at least one kind of Ca, Mg and Zr) may be mentioned.

Among these, it is preferable to use one kind selected from neodymium gallium garnet, samarium gallium garnet, gadolinium gallium garnet and X-substituted gadolinium gallium garnet (note that X is at least one kind of Ca, Mg and Zr), but it is not limited to the above as far as it is a garnet-based material being stable with a lead oxide flux.

A method of producing the base substrate 10 in the magnetic garnet single crystal film formation substrate of the present invention is not particularly limited, and a method commonly used in producing a conventional GGG single crystal substrate, etc. can be applied.

For example, first, a homogenous molten mixture is prepared wherein each of or two or more selected kinds of elements expressed by M1, elements expressed by M2 and elements expressed by M3 in the above general formula and each of or two or more selected kinds of elements expressed by M4 and elements expressed by M5 used depending on the case are contained at a predetermined ratio. Next, a polycrystalline body is formed from the molten mixture, for example, by dipping GGG seed crystal, etc. having a long axis direction of <111> perpendicular to the liquid surface and pulling up while slowly rotating.

Since there are a large number of cracks on the polycrystalline body, a single crystal portion without a crack is selected from that and, after confirming the crystal orientation, it is dipped as a seed crystal in the above molten mixture so that the crystal orientation <111> becomes perpendicular to the liquid surface and pulled up while slowly rotating, consequently, a single crystal without a crack is formed. Next, the single crystal is cut perpendicular to the growth direction to be a predetermined thickness, performing mirror polishing on the both surfaces, and'performing etching processing, for example, with heat phosphoric acid, etc. to obtain the base substrate 10.

The buffer layer 11 composed of a garnet-based single crystal thin film having the above composition is formed on the thus obtained base substrate 10 by a sputtering method, a CVD method, a pulse laser vapor deposition method, a solution method or other thin film formation technique.

By using the thus obtained magnetic garnet single crystal film formation substrate 2, a magnetic garnet single crystal film 12 composed of a bismuth-substituted rare earth iron garnet single crystal film is formed by the liquid phase epitaxial growth method. The composition of the bismuth-substituted rare earth iron garnet single crystal film to be formed is expressed by, for example, a general formula BiₘR₃₋ₘFe₅₋ₙMnO₁₂ (R is at least one kind of rare earth elements, M is at least one kind of element selected from Ga, Al, In, Sc, Si, Ti, Ge and Mg, and ranges of "m" and "n" are 0<m<3.0 and 0≤n≤1.5 in the formula).

In the general formula, as the rare earth element expressed by R, for example, Y, La, Pr, Nd, Sm, Eu, Gd, Tb, Dy, Ho, Er, Tm, Yb, Lu, etc. are mentioned, and one or more kinds of these may be included.

In the single crystal, a part of the rare earth element expressed by R is substituted with bismuth, the ratio of the substitution with bismuth is expressed by "m" and the value of "m" is in a range of 0<m<3.0. Particularly when "m" is in the range of 0.5 to 1.5, the thermal expansion coefficient of the single crystal and that of the single crystal substrate become extremely close, so it is advantageous. Also, "M" is a nonmagnetic element substitutable with Fe, which are Ga, Al, In, So, Si, Ti, Ge and Mg, and one or more kinds of these may be included. The ratio "n" of the substitution with Fe in the nonmagnetic element is selected from the range of 0 to 1.5.

To form a bismuth-substituted rare earth iron garnet single crystal film by the liquid phase epitaxial growth method, a homogenous molten mixture containing a predetermined ratio of (1) a bismuth oxide, (2) at least one kind of rare earth element oxide, (3) an ion oxide and (4) an oxide of at least one kind of element selected from Ga, Al, In, Sc, Si, Ti, Ge and Mg used depending on the case is prepared. As a solute for precipitation, a lead oxide is normally used as a main component, but a bismuth oxide or other solute for precipitation may be used. Also, a boron oxide, etc. may be also included as a crystal growth auxiliary if desired.

Next, by dipping the substrate 2 of the present invention in the molten mixture, a single crystal is grown by epitaxial-growth from the molten mixture on a surface of the buffer layer 11 of the substrate 2 so as to form a magnetic garnet single crystal film. A temperature of the molten mixture at this time varies depending on a composition of the material mixture, but is normally selected from a range of 600 to 1000°C. Also, the substrate 2 may be subjected to epitaxial growth by being left in the molten mixture or by being suitably rotated. When rotating the substrate 2, the speed of the rotation is preferably 10 to 200 rpm. Also, the speed of film formation is normally 0.08 to 0.8 µm/minute or so. The dipping time varies depending on the film formation speed and a desired film thickness, etc. and cannot be determined as a rule, but is normally 10 to 100 hours or so.

After finishing the epitaxial growth, the substrate 2 is pulled out from the molten mixture and adhered molten mixture is sufficiently swished off, then, cooled to the room temperature. Next, after removing a caked substance of the molten mixture adhered to the surface of the formed single crystal film is removed by being dipped in a mineral acid solution of aqua fortis, etc., it is washed with water and dried. The thickness of the magnetic garnet single crystal film 12 composed of bismuth-substituted rare earth iron garnet single crystal formed on the substrate 2 as above is normally in a range of 100 to 1000 µm. Also, the thermal expansion coefficient is 1.0 × 10⁻⁵/°C to 1.2 × 10⁻⁵/°C or so in the room temperature to 850°C.

As explained above, the crystal structure and composition of the bismuth-substituted rare earth iron garnet single crystal film formed on the substrate 2 can be identified respectively by composition analysis by X-ray diffraction and a fluorescent X-ray, etc. Also, performance of the single crystal film 12 can be evaluated by removing the substrate 2 from the single crystal film 12 by polish processing, etc., then, performing polish processing on both surfaces of the film 12, providing non-reflection film on the both surfaces, and obtaining a Faraday rotation coefficient, transmission loss and temperature property, etc.

Below, the present invention will be explained further in detail by examples and comparative examples.

### Example 1

CaCO₃, Nb₂O₅ and Ga₂O₃ were weighed, fired at 1350°C in the air, and after confirming a garnet single phase, put in an iridium melting pot, heated to be about 1450°C by high frequency induction in a mixed gas atmosphere of 98 volume% of a nitrogen gas and 2 volume% of an oxygen gas and melted, so that a composition of the melt becomes Ca₃Nb_{1.7}Ga_{3.2}O₁₂. After that, a seed crystal of the above composition having a 5mm square column shape wherein the long axis direction is <111> is dipped in this melt to be perpendicular to the liquid surface and pulled up at a speed of 3 mm/hour while rotating at 20 rpm, consequently, transparent single crystal having no cracks at all was obtained.

Next, a sample of about 1g was cut from each of its upper portion and lower portion of the crystal for quantitative analysis of respective composing elements by a fluorescent X-ray analysis apparatus. It was confirmed that both of the upper portion and the lower portion of the crystal had a composition of Ca₃Nb_{1.7}Ga_{3.2}O₁₂ (CNGG).

The obtained single crystal was cut to be a predetermined thickness vertically to the growing direction, and after performing mirror-polishing on the both sides, etching processing with heat phosphoric acid was performed, so that a CNGG single crystal substrate (base substrate 10) was prepared. The thermal expansion coefficient (α) of the single crystal substrate at the room temperature to 850°C was 1.07 × 10⁻⁵/°C. The thickness of the CNGG single crystal substrate was 0.6 mm.

An Nd₃Ga₅O₁₂ (NGG) thin film (buffer layer 11) was formed by the sputtering method on the CNGG single crystal substrate. Specifically, an NGG sintered body was used as a target, sputtering film formation was performed under film formation condition below, and anneal processing was performed after that.

### [Sputtering Film Formation Condition]

substrate temperature: 600°C
input: 300W
atmosphere: Ar + O₂ (10 volume%), 1 Pa
film formation time: 30 minutes
film thickness: 250 nm

### [Anneal Processing]

atmosphere: O₂, 1 atm
temperature: 800°C
time: 30 minutes

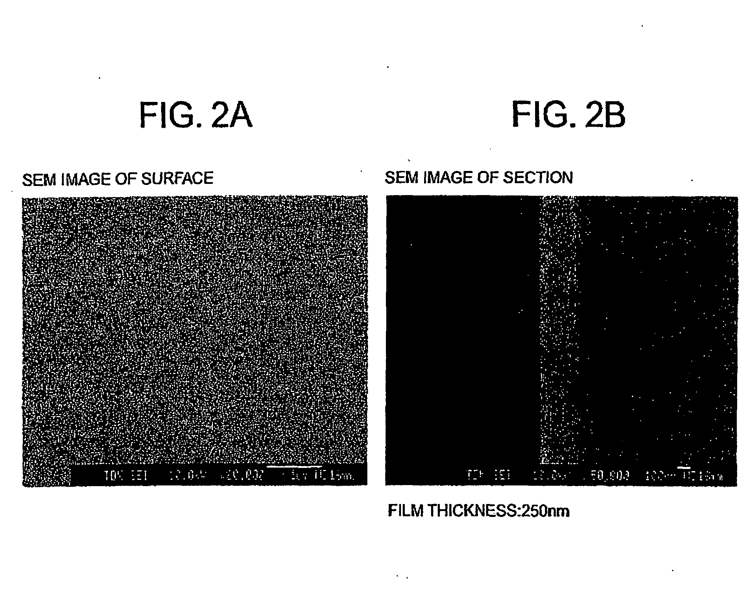

A SEM image of the NGG film surface is shown in FIG. 2A. Also, a SEM image of the section is shown in FIG. 2B. It was confirmed that a flat and smooth NGG film could be obtained. Also, when conducting composition analysis of the NGG film by a fluorescent X-ray, it was confirmed that a Nd₃Ga₅O₁₂ (NGG) thin film having an approximate stoichiometric composition was obtained.

By using the thus obtained CNGG substrate added with the NGG film, a bismuth-substituted rare earth iron garnet single crystal film was formed by the liquid phase epitaxial growth method. Specifically, 5.747g of Ho₂O₃, 6.724g of Gd₂O₃, 43.21g of B₂O₃, 126.84g of Fe₂O₃, 989.6g of PbO and 826.4g of Bi₂O₃ were put in a melting pot made by platinum, melted at about 1000°C and mixed to be homogenized, then, cooled at a rate of 120°C/hr. and kept in a supersaturated state at 832°C. Next, a substrate obtained by forming an NGG thin film having a thickness of 250 nm on a CNGG substrate having a thickness of 0.6 mm was dipped in this melt and liquid phase epitaxial growth was performed for 10 minutes to grow a single crystal film while rotating the substrate at 100 rpm, so that a bismuth-substituted rare earth iron garnet single crystal film having a film thickness of 4 µm was formed on the substrate.

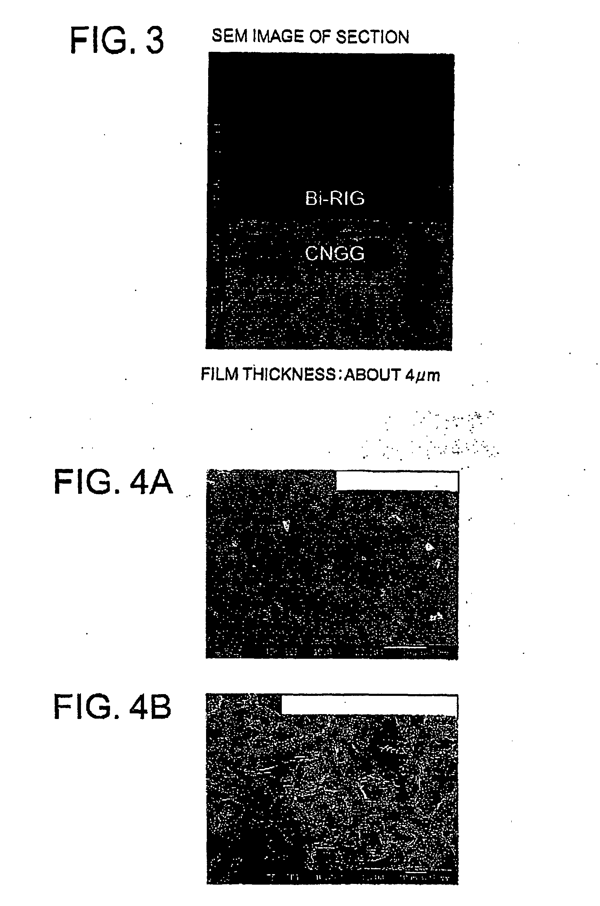

When analyzing a composition of the single crystal film by a fluorescent X-ray method, it was confirmed to be Bi_{1.1}Gd_{1.1}Ho_{0.8}Fe_{5.0}O₁₂ (Bi-RIG). A SEM image of a section of the single crystal film is shown in FIG. 3 and a SEM image of a surface thereof is shown in FIG. 4A. It was confirmed that a Bi-RIG film having a flat, smooth and fine surface and of an approximate stoichiometric composition could be formed by epitaxial growth. Also, when measuring a difference of a lattice constant of the single crystal film and that of the CNGG substrate as a base substrate, it was confirmed to be 0.009Å and within ±0.02Å. Note that when measuring a difference of the lattice constant of the single crystal film and that of the NGG thin film as a buffer layer, it was 0.007Å. Measurement of the lattice constant was made by a X-ray diffraction method.

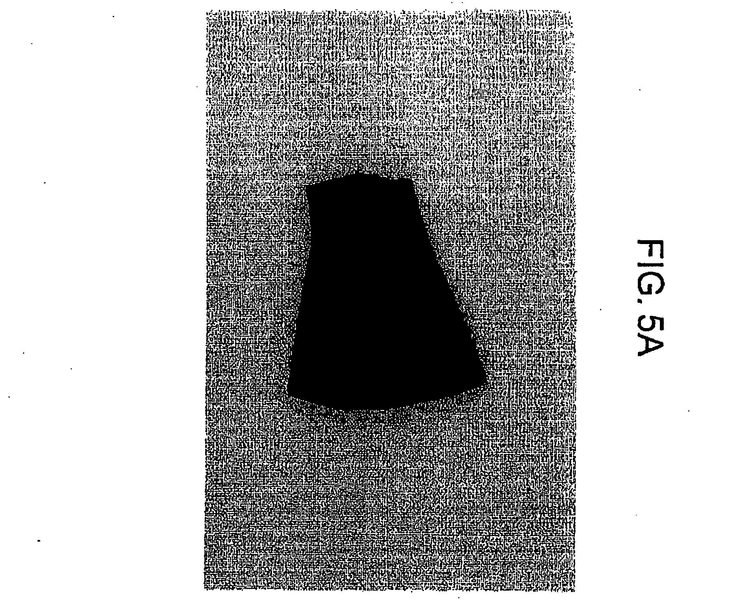

Also, by using other sample, the liquid phase epitaxial growth was performed for 30 hours under the same condition as above and a bismuth-substituted rare earth iron garnet single crystal film having a film thickness of about 470 µm was formed on the substrate. A picture of the single crystal film formed on the substrate is shown in FIG. 5A.

Arising of cracks was not observed in both of the obtained single crystal film and the single crystal substrate. When analyzing a composition of the single crystal film by the fluorescent X-ray method, it was confirmed to be Bi_{1.1}Gd_{1.1}Ho_{0.8}Fe_{5.0}O₁₂.

Also, by removing the substrate from the single crystal film by polishing processing, performing polishing processing on the both sides of the single crystal film, adhering a non-reflection film made by SiO₂ or Ta₂O₅ on both sides thereof, and evaluating a Faraday rotation angle at a wavelength of 1.55 µm and a transmission loss at a Faraday rotation angle of 45 degrees and a temperature characteristic, the Faraday rotation coefficient was 0.119 deg/µm, the transmission loss was 0.03 dB, and the temperature characteristic was 0.065 deg/°C. These are all at satisfactory levels as optical characteristics of an optical isolator.

Note that the Faraday rotation angle was obtained by letting a polarized laser light having a wavelength of 1.55 µm enter the single crystal film and measuring an angle of the deflecting surface of the emitted light. The transmission loss was obtained from a difference of intensity of the laser light having a wavelength of 1.55 µm passed through the single crystal film and light intensity in a state without a single crystal film. The temperature characteristic was calculated from a value obtained by measuring a rotation angle by changing a temperature of the sample from -40°C to 85°C.

Furthermore, the thermal expansion coefficient (α) of the single crystal film at the room temperature to 850°C was 1.10 × 10⁻⁵/°C. The difference of the thermal expansion coefficient between the base substrate and the single crystal film was 0.03 × 10⁻⁵/°C. Also, arising of cracks was not observed in the obtained single crystal film.

### Example 2

A CNGG single crystal substrate was prepared in the same method as in the above example 1.

A Gd_{2.65}Ca_{0.35}Ga_{4.05}Mg_{0.3}Zr_{0.65}O₁₂ (GCGMZG) thin film was formed on the CNGG single crystal substrate by the pulse laser vapor deposition method. Specifically, a KrF excimer laser was irradiated at an irradiation laser density of 2.0 J/cm² on a GCGMZG single crystal target, and a GCGMZG thin film having a film thickness of about 10 nm was formed under an oxygen partial pressure of 1 Pa and an irradiation time of 5 minutes on the CNGG substrate kept at a substrate temperature of 800°C. When conducting fluorescent X-ray analysis on the GCGMZG thin film, it was confirmed to be a GCGMZG having the same composition as that of the target.

By using the thus obtained CNGG single crystal substrate added with the GCGMZG thin film, a bismuth-substituted rare earth iron garnet single crystal film was formed by the liquid phase epitaxial growth method in the same way as in the example 1. Arising of cracks was not observed in the obtained single crystal film.

### Comparative Example 1

A CNGG single crystal substrate was prepared in the same method as in the example 1, and a bismuth-substituted rare earth iron garnet single crystal film was formed by the liquid phase epitaxial growth method in the same way as in the example 1 without forming thereon a buffer layer composed of a single crystal thin film which is stable with a lead oxide.

FIG. 4B is a SEM image of a surface of a substrate after the experiment, and it was confirmed that the surface was etched. Also, it was found by the fluorescent X-ray analysis that a bismuth-substituted rare earth iron garnet single crystal film was not formed.

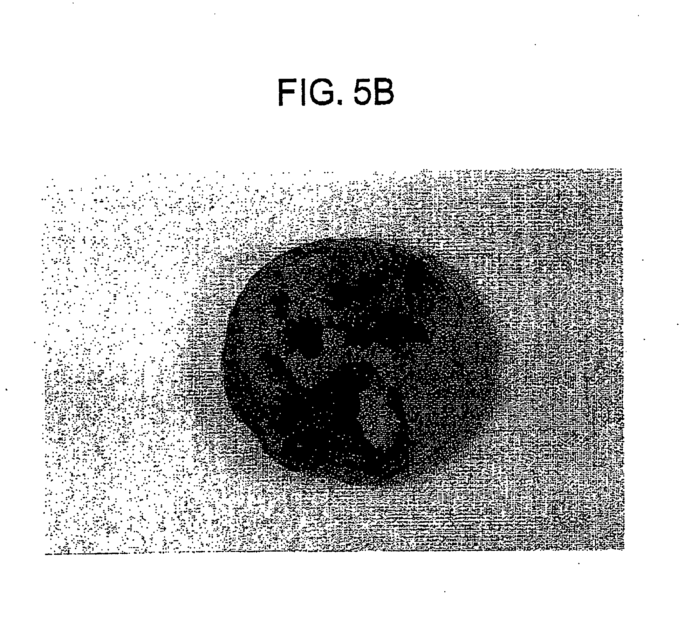

Also, FIG. 5B is a picture of the whole bismuth-substituted rare earth iron garnet single crystal film grown in the comparative example 1, and it was confirmed that a film was unevenly formed on the surface of the substrate and a part thereof was come off.

### Example 3

A CNGG single crystal substrate added with an NGG thin film was prepared in the same method as in the above example 1. By using the CNGG single crystal substrate added with an NGG thin film, a bismuth-substituted rare earth iron garnet single crystal film was formed by the liquid phase epitaxial growth method.

Specifically, 12.431g of Tb₄O₇, 1.464g of Yb₂O₃, 43.21g of B₂O₃, 121.56g of Fe₂O₃, 989.6g of PbO and 826.4g of Bi₂O₃ are put in a melting pot made by platinum, melted at about 1000°C, mixed to be homogenized, cooled at a rate of 120°C/hr. and kept in a supersaturated state at 840°C. Next, a single crystal substrate material obtained by forming an NGG thin film of 250 nm on a CNGG substrate having a substrate thickness of 0.6 mm is dipped in this solution, liquid phase epitaxial growth was performed for 43 hours to grow a single crystal film while rotating the substrate at 100 rpm, so that a bismuth-substituted rare earth iron garnet single crystal film having a film thickness of 560 µm was formed on the substrate.

Arising of cracks was not observed in both of the obtained single crystal film and single crystal substrate. When analyzing a composition of the single crystal film by the fluorescent X-ray method, it was confirmed to be Bi_{1.0}Tb_{1.9}Yb_{0.1}Fe_{5.0}O₁₂.

Also, when measuring a difference of a lattice constant of the single crystal film and that of the CNGG substrate as a base substrate, it was confirmed to be 0.005Å and within ±0.02Å. Note that when measuring a difference of the lattice constant of the single crystal film and that of the NGG thin film as a buffer layer, it was 0.004Å.

Also, when evaluating a Faraday rotation angle at a wavelength of 1.55 µm and a transmission loss at a Faraday rotation angle of 45 degrees and temperature characteristic, the Faraday rotation coefficient was 0.102 deg/µm, the transmission loss was 0.09 dB, and the temperature characteristic was 0.051 deg/°C. Furthermore, the thermal expansion coefficient of the single crystal film was 1.09 × 10⁻⁵/°C. The difference of the thermal expansion coefficient between the base substrate and the single crystal film was 0.02 × 10⁻⁵/°C. Also, arising of cracks was not observed in the obtained single crystal film.

### Example 4

A CNGG single crystal substrate added with an NGG thin film was prepared in the same method as in the above example 1. By using the CNGG single crystal substrate added with the NGG thin film, a bismuth-substituted rare earth iron garnet single crystal film was formed by the liquid phase epitaxial growth method.

Specifically, 7.653g of Gd₂O₉, 6.778g of Yb₂O₃, 43.21g of B₂O₃, 113.2g of Fe₂O₃, 19.02g of Ga₂O₃, 3.35g of Al₂O₃, 869.7g of PbO and 946.3g of Bi₂O₃ are put in a melting pot made by platinum, melted at about 1000°C, mixed to be homogenized, cooled at a rate of 120°C/hr. and kept in a supersaturated state at 829°C. Next, a single crystal substrate material obtained by forming 250 nm of an NGG thin film on a CNGG substrate having a substrate thickness of 0.6 mm is dipped in this solution, liquid phase epitaxial growth was performed for 43 hours to grow a single crystal film while rotating the substrate at 100 rpm, so that a bismuth-substituted rare earth iron garnet single crystal film having a film thickness of 520 µm was formed on the substrate.

Arising of cracks was not observed in both of the obtained single crystal film and single crystal substrate. When analyzing a composition of the single crystal film by the fluorescent X-ray method, it was confirmed to be Bi_{1.3}Gd_{1.2}Yb_{0.5}Fe_{4.2}Ga_{0.6}Al_{0.2}O₁₂.

Also, when measuring a difference of a lattice constant of the single crystal film and that of the CNGG substrate as a base substrate, it was confirmed to be 0.014Å and within ±0.02Å. Note that when measuring the difference of the lattice constant of the single crystal film and that of the NGG thin film as a buffer layer, it was 0.013Å.

Also, when evaluating a Faraday rotation angle at a wavelength of 1.55 µm and a transmission loss at a Faraday rotation angle of 45 degrees and temperature characteristic, the Faraday rotation coefficient was 0.113 deg/µm, the transmission loss was 0.02 dB, and the temperature characteristic was 0.096 deg/°C. Furthermore, the thermal expansion coefficient of the single crystal film was 1.05 × 10⁻⁵/°C. The difference of the thermal expansion coefficient between the base substrate and the single crystal film was 0.02 × 10⁻⁵/°C. Also, arising of cracks was not observed in the obtained single crystal film.

### Evaluation

According to the examples 1 to 4; the single crystal film was grown evenly and the crystal surface was smooth and shiny as shown in FIG. 5A, while according to the comparative example 1, it was observed that the single crystal film did not grow evenly and flaking arose partially as a result that reaction was caused on a boundary surface of the growing film and the substrate.

The above explained embodiments and examples are for illustrating the present invention and not to limit the present invention, and the present invention can be carried out in a variety of other modified embodiments.

## Claims

1. A magnetic garnet single crystal film formation substrate for growing a magnetic garnet single crystal film by liquid phase epitaxial growth, comprising:
a base substrate composed of a garnet-based single crystal which is unstable with a flux used for the liquid phase epitaxial growth; and
a buffer layer composed of a garnet-based single crystal thin film formed on said base substrate and being stable with said flux.

2. The magnetic garnet single crystal film formation substrate as set forth in claim 1, **characterized by** including a lead oxide and/or a bismuth oxide as a main component of said flux.

3. The magnetic garnet single crystal film formation substrate as set forth in claim 1 or 2, **characterized in that** said base substrate has an approximately same thermal expansion coefficient as that of said magnetic garnet single crystal film.

4. The magnetic garnet single crystal film formation substrate as set forth in claim 3, **characterized in that** a difference between the thermal expansion coefficient of said base substrate and the thermal expansion coefficient of said magnetic garnet single crystal film is within a range of ±2 × 10⁻⁶/°C or less in a temperature range of 0°C to 1000°C.

5. The magnetic garnet single crystal film formation substrate as set forth in any one of claims 1 to 4, **characterized in that** said base substrate has an approximately same lattice constant as that of said magnetic garnet single crystal film.

6. The magnetic garnet single crystal film formation substrate as set forth in claim 5, **characterized in that** a difference between the lattice constant of said base substrate and the lattice constant of said magnetic garnet single crystal film is within a range of ±0.02Å or less.

7. The magnetic garnet single crystal film formation substrate as set forth in'any one of claims 1 to 6, **characterized in that** said base substrate includes Nb or Ta.

8. The magnetic garnet single crystal film formation substrate as set forth in any one of claims 1 to 7, **characterized in that** said buffer layer is a garnet-based single crystal thin film substantially not including Nb and Ta.

9. The magnetic garnet single crystal film formation substrate as set forth in any one of claims 1 to 8, **characterized in that** said buffer layer is
expressed by a general formula R₃M₅O₁₂ (note that R is at least one of rare earth elements and M is one selected from Ga and Fe)
or
an X-substituted gadolinium gallium garnet (note that X is at least one of Ca, Mg and Zr).

10. The magnetic garnet single crystal film formation substrate as set forth in any one of claims 1 to 9, **characterized in that** a thickness of said buffer layer is 1 to 10000 nm and a thickness of said base substrate is 0.1 to 5 mm.

11. A method of producing a magnetic garnet single crystal film, including the step of growing a magnetic garnet single crystal film on said buffer layer by using the magnetic garnet single crystal film formation substrate as set forth in any one of claims 1 to 10 by a liquid phase epitaxial growth method.

12. A method of producing an optical element, including the steps of forming a magnetic garnet single crystal film by using the method of producing a magnetic garnet single crystal film as set forth in claim 11, and after that, removing said base substrate and buffer layer so as to form an optical element composed of a magnetic garnet single crystal film.

13. An optical element obtained by the method of producing an optical element as set forth in claim 12.
